# EUROPEAN PATENT APPLICATION

(11) **EP 2 224 123 A1**
(43) Date of publication of application: **01.09.2010**
(21) Application number: 09153605.2
(22) Date of filing: 25.02.2009
(51) Int. Cl.: F02M 51/00, F02M 51/06, F02M 61/16

(54) **Piezoelectric actuator**

(71) Applicant: Delphi Technologies Holding S.à.r.l., 4940 Bascharage (LU)
(72) Inventor: Koppe, Alain, F-57480, Haute-Kontz (FR); Schlosser, Davy, 57700 Hayange (FR)
(74) Representative: Gregory, John David Charles

(57) **Abstract**

A piezoelectric actuator (54), particularly for use in an automotive fuel injector includes a piezoelectric stack (60), a connector module (68) associated with the piezoelectric stack, and connecting means (110) for electrically connecting the piezoelectric stack to the connector module. The connecting means comprises a collar (112) that is received over the piezoelectric stack and is locatable in a position in which the collar contacts a first electrode pair (62a, 62b) provided on the piezoelectric stack and a second electrode pair (98a, 98b; 102a, 102b) provided on the connector module thereby providing an electrical connection between the connector module and the piezoelectric stack.

## Description

### Technical Field

The invention relates to a piezoelectric actuator, and more particularly a multilayer piezoelectric stack-type actuator for use in a piezoelectrically actuated injector of an internal combustion engine. The invention also relates to a method of assembling such a piezoelectric actuator.

### Background of the invention

Piezoelectric fuel injectors generally employ piezoelectric actuators comprised of a stack of piezoelectric elements, arranged mechanically in series, to open and close an injection valve in order to inject fuel into a combustion space. Typically, a piezoelectric actuator is located in a chamber defined by an injector housing which contains fuel at injection pressures. The piezoelectric actuator controls movement of the injection valve either by means of a mechanical or hydraulic coupling. An example of one such piezoelectric fuel injector is disclosed in European Patent No. 0995901.

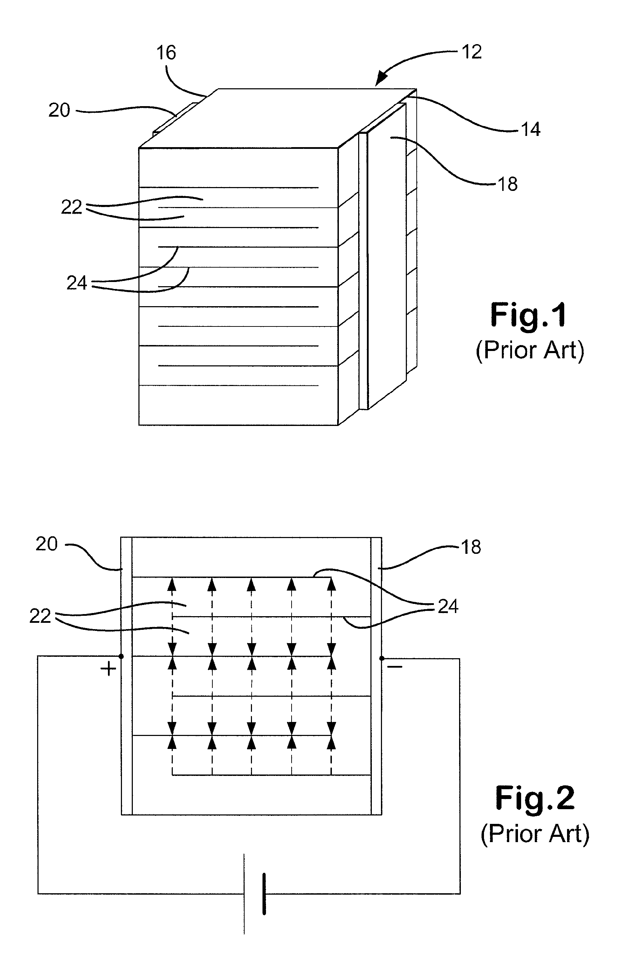

A typical multi-layer piezoelectric actuator is shown in Figure 1 and comprises a stack body 12, which is generally rectangular in cross section, having first and second opposing outer faces 14, 16. The opposing faces 14, 16 of the stack body 12 are provided with first and second conductors or distribution electrodes 18, 20 respectively. The stack body 12 comprises a plurality of relatively thin piezoelectric ceramic layers or elements 22, each of which is spaced from adjacent elements 22 by an internal electrode 24. Alternate ones of the internal electrodes 24 are electrically connected to the first distribution electrode 18 and second distribution electrode 20, respectively, to form two groups of electrodes, whereby the electrodes of one group are interdigitated with the electrodes of the other group.

With reference also to Figure 2, a voltage is applied, in use, across the two distribution electrodes 18, 20 whereby an adjacent pair of internal electrodes 24 sandwiching a piezoelectric element 22 become mutual conductors of opposite polarity and apply an electric field to the intermediate element 22. Put another way, the distribution electrodes 18, 20 serve to distribute charge to each group of the internal electrodes 24 to which they are connected. When an electric field is applied to the distribution electrodes 18, 20, the piezoelectric actuator will elongate (if the piezoelectric actuator is of the energise-to-extend type) or contract (if the piezoelectric actuator is of the de-energise-to-extend type) along its longitudinal axis.

Each piezoelectric element 22 is a dielectric material such that it is a poor conductor of electrical charge and, therefore, serves to insulate opposing internal electrodes 24 whilst supporting electric fields generated therebetween. Typically, each piezoelectric element 22 has a thickness of around 100µm, so a relatively high electric field strength of, for example, 2kV/mm can be attained between the internal electrodes 24 by way of a relatively low applied voltage of 200V, whilst still obtaining the required elongation or contraction of the actuator stack.

Although not shown in Figures 1 and 2, a connector module sits on top of the stack body 12, in use, and is secured by gluing, for example. The connector module includes an insulating block-like body through which extend a pair of conductive rods. The pair of conductive rods terminate at the lower end of the connector module and connect to respective contact electrodes that extend through the module to terminate at respective outer faces of the module. A conductive strip of e.g. copper spans the connector module and the stack body 12 and connects the contact electrodes of the connector module to the distribution electrodes 18, 20 of the stack body 12. The conductive strip must be located precisely during manufacture and welded in place.

Assembly of a piezoelectric actuator like the one described above is process intensive. It is therefore desirable for an alternative design of piezoelectric actuator that may be assembled more efficiently.

### Summary of the invention

It is against this background that the invention provides a piezoelectric actuator for a fuel injector including a piezoelectric stack, a connector module associated with the piezoelectric stack, and connecting means for electrically connecting the piezoelectric stack to the connector module. The connecting means comprises a collar that is received over the piezoelectric stack and is locatable in a position in which the collar contacts a first electrode pair provided on the piezoelectric stack and a second electrode pair provided on the connector module thereby providing an electrical connection between the connector module and the piezoelectric stack.

The collar may comprise a ring of insulating material, optionally polyimide, or another suitable fluoropolymer, which includes first and second conductor pads housed within the insulating ring that connect the first electrode pair provided on the stack to the second electrode pair provided on the connector module. The conductor pads may be copper laminate, although other conductive materials are also appropriate.

The collar may also include a conductive member that connects the first conductor pad to the second conductor pad which may be provided with a resistive element to provide an energy discharge function. The resistive element may be an chip resistor that is integrated with the conductive member. The integration of the chip resistor with the collar avoids the requirement of a discharge resistor to be fitted elsewhere on the piezoelectric actuator, for example between the actuator power terminals or as a resistive layer within the stack itself. Advantageously, therefore, this modification reduces the cost of the piezoelectric actuator itself and also makes manufacturing less complex. Alternatively, the resistor may be formed from a shaped part of the conductor link that connects the two conductor pads, thus integrating the resistor function within the conductive member.

Furthermore, embedding the conductive member in the insulating material provides protection which is beneficial in a chemically aggressive operating environment such as is found in a fuel injector.

In one embodiment, each of the second pair of electrodes of the connector module are provided with a recess that is shaped for mutual cooperation with a respective conductor pad of the collar. Advantageously, this improves manufacturing efficiency since the conductor pads may be urged up against the second electrode pair provided on the connector module to achieve electrical connection which requires only a single manufacturing step. This makes manufacturing easier since the conductive pads/tabs mate with the contact faces locating them in the correct position for welding/soldering.

From another aspect, the invention provides a connecting element suitable for use with a stack-type piezoelectric actuator as described above. The connecting element comprises an non-conductive collar shaped such that a piezoelectric stack is receivable therethrough, in use, wherein the collar includes conductive means integrated therein. In order for the collar to fit over a piezoelectric stack, the collar may comprise a ring or part-ring of insulating material.

It should be appreciated that preferred and/or optional features of the first aspect of the invention may also be combined with the second aspect of the invention.

In another aspect, there is provided a method of assembling a piezoelectric actuator including providing a piezoelectric stack having distribution electrode means, receiving a connecting element as described above over the piezoelectric stack, joining a connector module having electrode means to the piezoelectric stack, moving the connecting element relative to the stack such that conductive means provided in the connecting element engages with the distribution electrode means of the piezoelectric stack.

The method may also include securing the conductive means of the connecting element to the distribution electrode means of the piezoelectric stack and the electrode means of the connector module.

### Brief description of the drawings

Reference has already been made to Figure 1, which is a perspective view of a known multilayer piezoelectric actuator, and Figure 2 which is a schematic view of the piezoelectric actuator of Figure 1 that illustrates the electric field generated when a voltage is applied to the actuator. In order for the invention to be better understood, it will now be described, by way of example only, with reference to the accompanying drawings, in which:
Figure 3 is a sectioned view of a fuel injector incorporating a piezoelectric actuator in accordance with the invention;
Figure 4 is a perspective view of a fully assembled piezoelectric actuator in accordance with the invention, and as shown in Figure 3;
Figure 5 is an enlarged perspective view of part of the piezoelectric actuator of Figure 3;
Figure 6 is a perspective view comparable to that of Figure 5 but with the connector module 'ghosted' to show hidden detail;
Figure 7 is a perspective view of only the connecting collar of the piezoelectric actuator; and
Figure 8 is a perspective view of an alternative embodiment of the connecting collar shown in Figures 4 to 7.

### Specific description of the embodiments

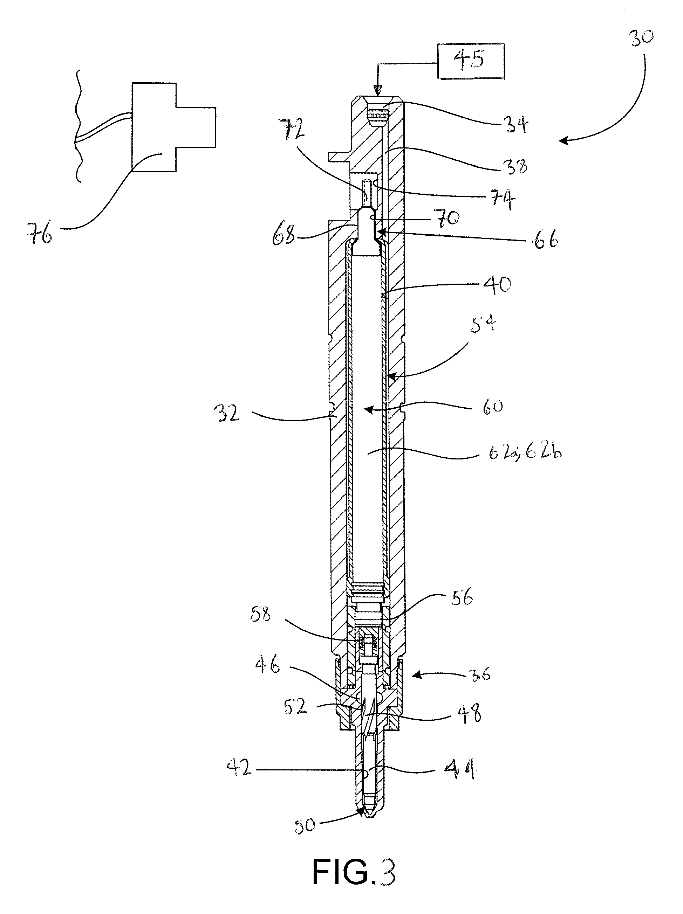

Figure 3 shows a fuel injector, indicated generally as 30, suitable for use in an internal combustion engine, particularly a compression-ignition internal combustion engine, or 'diesel engine'. The fuel injector 30 includes an injector body 32 having a first, upper end defining an inlet 34 for connection to a fuel source, and a second, lower end to which an injector nozzle body 36 is connected. It should be appreciated that the terms 'upper' and 'lower' are referred to in the context of the drawings and are not intended to limit any of the components thereby described to a specific orientation.

Between its two ends, the injector body 32 defines passageways for fuel in the form of an inlet passage 38 that extends downwards and away from the injector inlet 34 and leads to a fluid chamber 40. Although not shown clearly in Figure 3, the fluid chamber 40 is arranged to be in fluid communication with an axial bore 42 provided in the nozzle body 36, within which a valve needle 44 is slidable.

Pressurised fuel is supplied to the injector body 32 via the inlet 34 from a common rail or other suitable source of pressurised fuel 45. Such a source of pressurised fuel may also be arranged to supply fuel to one or more other injectors of the engine in a known manner. Pressurised fuel is conveyed from the inlet 34, through the inlet passage 38 and the fluid chamber 40, in turn, to an annular chamber 46 defined by the axial bore 42 of the nozzle body 32.

The annular chamber 46 surrounds the outer periphery of an upper portion 48 of the valve needle 44 and constitutes a delivery chamber from which fuel is directed to flow in the direction of a nozzle tip 50 along fuel channels 52 provided in the valve needle 44. As the valve needle 44 moves out of engagement of the nozzle tip 50, pressurised fuel is delivered into an associated combustion chamber of the engine through one or more nozzle outlets (not shown in Figure 3).

The fluid chamber 40 houses a piezoelectric stack-type actuator, referred to generally as 54, for effecting linear movement of the valve needle 44. Linear expansion and contraction of the actuator 54 is transmitted to the valve needle 44 by a control piston 56 which is attached, or otherwise coupled, to a first, lowermost end of the actuator 54 and serves to control the volume, and therefore the pressure, of fuel within a control chamber 58 located at the back end of the valve needle 44. By controlling the pressure of fuel within the control chamber 58, the position of the control piston 56 controls whether or not fuel injection occurs through the outlets.

The actuator 54 comprises a stack 60 of piezoelectric elements, each of which is separated by an internal electrode layer. Although the individual piezoelectric elements and the internal electrodes are not visible in Figure 3, the general arrangement of such a stack is known in the art. The stack 60 is provided with distribution electrode means in the form of a pair of positive and negative distribution electrodes 62a, 62b that run longitudinally along opposing side faces of the stack, one on either side, and make electrical contact with the internal electrodes within the stack. Note that only one such electrode can be seen on Figure 3. The positive and negative distribution electrodes 62a, 62b are connected to an electrical connector arrangement 66 and serve to convey an actuation voltage to the internal electrodes from an external power supply (not shown) by which means the stack 60 is cause to expand and contract.

The electrical connector arrangement 66 includes a connector module 68 that is located at an upper end, or ceiling, of the fluid chamber 40 and which extends through a longitudinal drilling or channel 70 provided in the injector body 32. Although Figure 3 does not show the connector module 68 in detail, it can be seen that it includes electrical terminal means in the form of positive and negative terminal blades 72a, 72b (only one of which is shown in Figure 3) which project away from the connector module 68 and include free ends that reside in a plug recess 74 provided in the injector body 32.

The terminal blades 72a, 72b provide an electrical connection point for an external power supply plug 76 and serve to convey an actuation voltage to the distribution electrodes 62a, 62b and, thus, to the internal electrodes, via the connector module 68.

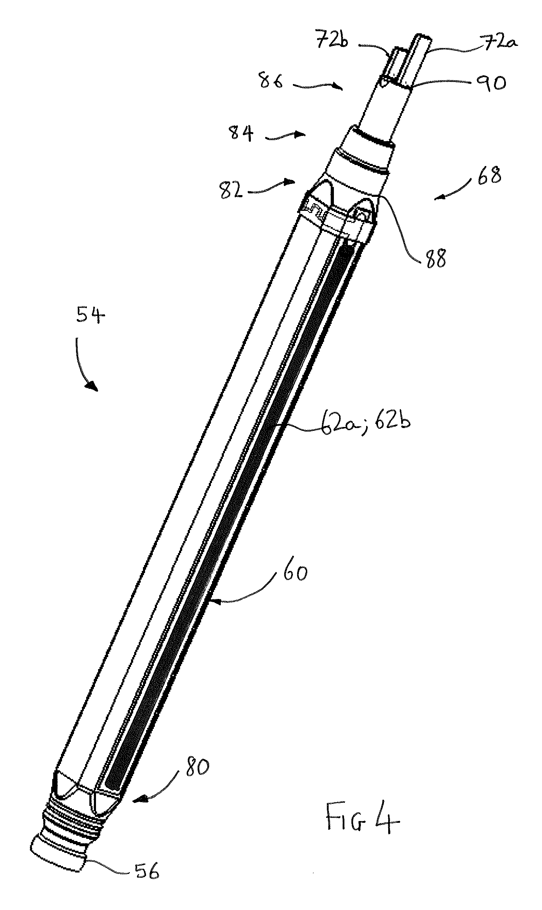

The piezoelectric actuator 54 and the connector module 68 will now be described in greater detail with reference to Figures 4, 5 and 6. Note that parts common to those in Figure 3 are denoted with like reference numerals.

As can be seen in Figure 4, the piezoelectric actuator 54 includes the elongate piezoelectric stack 60 upon which sits the connector module 68 and which is secured to the stack 60 by way of a suitable electrically compatible adhesive for example an epoxy resin such as ECCOBOND^{®}.

In this embodiment, the cross section of the stack 60 is generally octagonal having four flat side faces each of which is separated from its neighbouring side face by a curved corner face. The octagonal cross section of the stack 60 is beneficial for the purposes of packaging the actuator 54 within the fuel injector 30. However, the specific cross section described here is not essential for the invention and the invention applies equally to stacks with other cross section profiles, for example, square or circular.

It should be noted that although not shown in the figures the actuator 54 is, in practice, enveloped by a protective sheath. The protective sheath comprises a material that provides the actuator 54 with sufficient protection from the fuel laden environment in which the actuator resides, in use. Such a material may be, for example, PTFE or ETFE, although it should be appreciated that the exact nature and properties of the protective sheath are not central to the invention.

When installed on the actuator 54, the protective sheath extends from a lower edge 80 of the stack 60 to its upper edge, where the stack 60 interfaces, or joins, with the connector module 68. The protective sheath serves to protect the piezoelectric elements, the internal electrodes and the distribution electrodes 62a, 62b from attack by the operating environment.

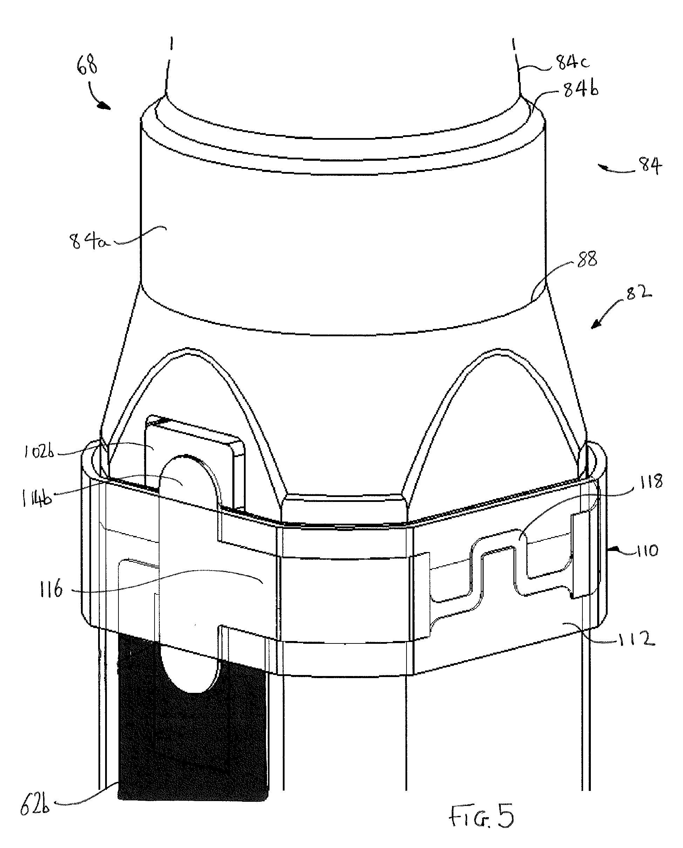

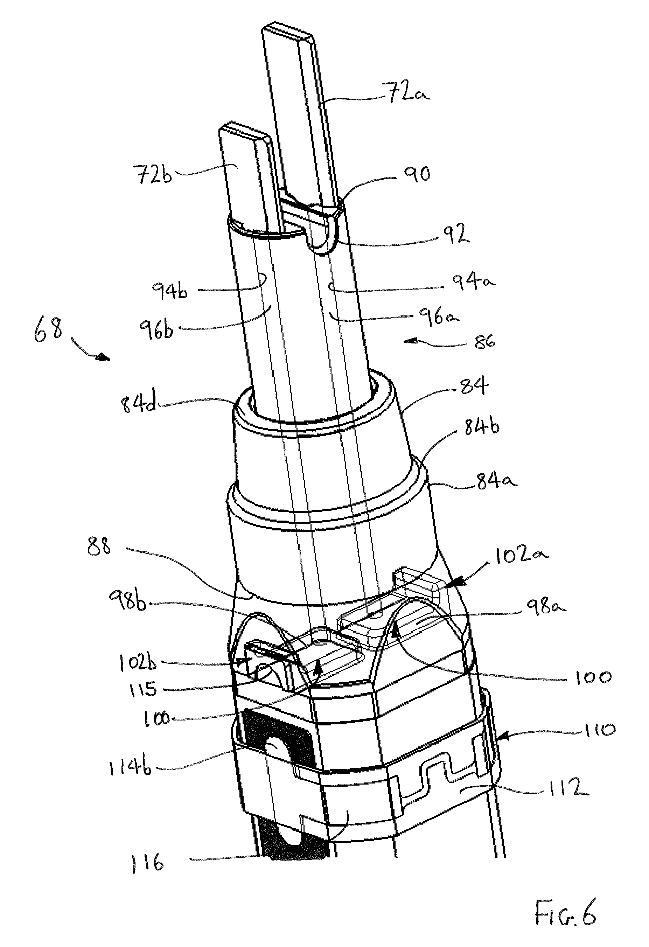

Referring now more specifically to Figures 5 and 6, which show the connector module 68 in more detail, the connector module 68 is of block like form and includes a base portion 82, an intermediate portion 84 or 'waist', and an upper portion 86 or 'neck'.

The base portion 82 includes a lower end face which lays adjacent the upper end face of the stack 60. The outer lateral profile of the lower end face of the base portion 82 is the same shape as the cross section of the stack 60, i.e. substantially octagonal, so that there are no overlapping areas when the two parts are joined together. Overlapping areas are undesirable since high pressure fuel will act on such overlaps, in use, exerting a force on the stack which can cause either the stack or the connector module to shift position.

The base portion 82 tapers inwardly in the upward direction from the octagonal lower end face into a circular transition edge 88 that defines a lower end of the generally cylindrical waist portion 84 of the connector module 68.

The waist portion 84 includes a cylindrical section 84a which extends upwards a short way and terminates in an annular step 84b that defines a shoulder. Above the annular step 84b, the waist portion 84 includes a taper section 84c of reduced diameter compared to that of the cylindrical section 84a, and which terminates at a second annular step 84d.

The neck portion 86 is generally cylindrical with a diameter smaller than that of the taper section 84c and rises from the second annular step 84d to terminate at an upper end face 90.

As shown most clearly in Figure 6, the first and second terminal blades 72a, 72b extend from the upper end face 90 of the connector module 68 and serve to connect to an electrical supply plug (76 - Figure 3), in use. It should be noted that the upper end face 90 of the neck portion 86 defines a channel 92 that runs laterally between the blades 72a, 72b and functions to guard against electrical short circuit between the blades 72a, 72b.

As also shown most clearly in Figure 6, the connector module 68 is provided with first and second bores 94a, 94b that extend along respective axes that are parallel to the longitudinal axis of the connector module 68 and spaced apart from each other, side by side. Each bore 94a, 94b receives a respective conductor member 96a, 96b in the form of a rod. Each conductor rod 96a, 96b has a first, lower end that protrudes at the lower face of the base portion 82 to engage with respective first and second metallic contact plates 98a, 98b located in generally rectangular recesses 100 provided on the underside of the base portion 82. Upper ends of the conductor rods 96a, 96b extend from the neck portion 86 and are connected to the terminal blades 72a, 72b by a suitable method, for example by welding.

The first and second contact plates 98a, 98b provide the connector module with first and second contact faces 102a, 102b that face radially outwards from opposing side faces of the base portion 82.

Referring again to Figure 5, the actuator 54 is provided with connecting means 110 (also referred to herein as connecting element) that connects the positive and negative contact faces 102a, 102b of the connector module 68 to the exposed positive and negative distribution electrodes 62a, 62b, respectively.

The connecting means 110 is an annular collar 112, or ring, that is received over the actuator 54 and spans the interface between the upper face of the stack 60 and the lower face of the connector module 68.

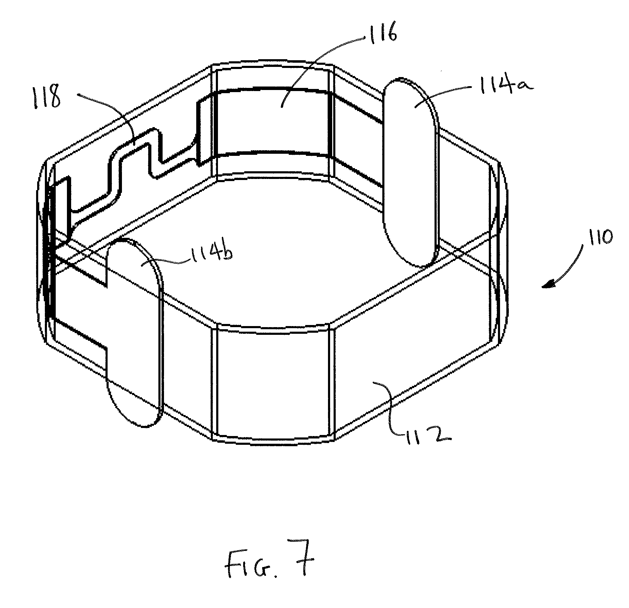

The collar 112 is a ribbon, or band, of flexible insulating material that is configured so as to define an internal shape and dimension substantially identical to the cross section of the piezoelectric stack 60. As shown more clearly in Figure 7, the collar 112 is shaped to define a generally octagonal thin-walled ring having four flat opposing side faces and four curved corner faces that separate the side faces. It should be noted that the collar 112 has sufficient rigidity to support its ring-shape when it is not installed on the stack, such rigidity enabling the collar to be handled more readily during manufacture.

In this embodiment the collar 112 is manufactured from polyimide since it has been found that this material has a beneficial combination of strength, rigidity, chemical and pressure resistance, and electrical insulation. However, it should be appreciated that polyimide is not essential to the invention and other materials could also provide an acceptable combination of physical and electrical properties, such as fluoropolymers that are resistant to diesel fuel and transmission oil and are capable of withstanding an operating environment around 200 degrees centigrade (°C).

The collar 112 includes first and second elongate conductive connector pads 114a, 114b, one on each of two opposing side faces of the collar 112 that correspond to the side faces of the stack 60 that bear the distribution electrodes 62a, 62b. The connector pads 114a, 114b are integrated within the insulating material of the collar 112 and extend longitudinally through it such that upper and lower ends of the connector pads 114a, 114b extend beyond, that is to say overhang, the upper and lower edges of the collar 112, respectively. Furthermore, outer faces of the connector pads are covered by the insulating material of the ring, and inner faces (that is to say, radially inward faces) of the connector pads 114a, 114b are not covered.

Figure 5, specifically, shows the collar 112 located in its second, or 'final' position. When the collar 112 is in this position, the upper ends of each of the connector pads 114a, 114b are engaged with a respective one of the contact faces 102a, 102b, and the lower end of each of the connector pads 114a, 114b contacts the respective distribution electrode 62a, 62b of the stack 60, thus forming the electrical connection between the connector module 68 and the stack 60. It should be noted that each of the contact faces 102a, 102b includes a semi-circular recess 115 (see Figure 6) which is shaped for mutual cooperation with the semicircular upper end of the respective conductor pad 114a, 114b. The recesses 115 enable the collar to be urged, or slid, into its correct position without having to guide the collar closely. This improves manufacturing efficiency.

In the embodiment shown, the connector pads 114a, 114b are connected to each other by a conductive member 116 comprising a conductive band that runs within the collar 112 transversely to the longitudinal axis of the stack 60. The conductive member 116 is a copper laminate having a suitable thickness of between approximately 70 and 100 microns. It should be noted also that in this embodiment the conductive member 116 is integral with the connector pads 114a, 114b.

The conductive member 116 extends from one of the connecting pads 114a, 114b to the other and includes at its mid-point a resistive element 118 of approximately one megaohm (1 MΩ). In this embodiment, the resistive element 118 is provided by a relatively thin meandering, or curved, conductive strip the cross sectional area of which is sized appropriately to provide the desired value of resistivity. It should be appreciated that the actual value of resistance is not essential to the present invention and may vary depending on the electrical specification and operating requirements of the stack.

Although the conductive member 116 and the associated resistive element 118 are not essential parts to provide the electrical connection between the connector module 68 and the stack 60, they provide a discharging function for the actuator 54 to ensure that the charge held on the stack 60 dissipates safely in the event of the actuator 54 being disconnected from its power source. This protects maintenance personnel from inadvertent stack discharge that could otherwise occur during a maintenance action, for example.

It should be appreciated that since the outer facing sides of the conductor pads 114a, 114b and the conductive member 116 are, at least partially, housed/contained within the insulating material, they are provided with protection from their operating environment. A further advantage of the collar is that it spans the join between the connector module and the stack, thereby providing a protective barrier for the join against high pressure fuel.

The configuration of the piezoelectric actuator 54 described above enables the actuator 54 to be assembled efficiently. In particular, since the collar 112 is ring shaped, therefore being slidable on the stack 60, the collar 112 can conveniently be pushed into its operational position after the connector module 68 is fixed to the top of the stack 60.

One way in which the actuator 54 may be assembled will now be described. Firstly, before the stack 60 and the connector module 68 are joined together, the collar 112 is received over the stack 60. At this point, therefore, the collar is slidable with respect to the stack 60 and the connecting pads 114a, 114b are not engaged with the contact faces 102a, 102b. This position of the collar 112 is exemplified in Figure 6 in which the connecting pads 114a, 114b are shown spaced from the contact faces 102a, 102b along the longitudinal axis of the stack 60.

Once the collar 112 is received over the stack 60, the connector module 68 is attached to the upper face of the stack 60. The collar 112 is then moved linearly along the stack 60 until the connector pads 114a, 114b engage with the shaped surfaces of the contact faces 102a, 102b, the position of which is shown clearly in Figure 5.

In order to secure the collar 112 in position, the exposed upper portion of each of the connector pads 114a, 114b are laser-micro-soldered or otherwise welded to the respective contact face 102a, 102b provided by the connector module 68. Likewise, the exposed lower portion of the connector pads 114a, 114b are soldered to the exposed part of the respective positive and negative external electrode 62a, 62b on the side surfaces of the stack 60. It will therefore be appreciated that the contact faces 102a, 102b provide a means to locate the collar 112 in its correct position for the micro-soldering operation which avoids the requirement to position and weld individual conductive strips to each side of the stack 60.

The skilled person will appreciate that various modifications to the embodiments described above are possible without departing from the inventive concept as defined by the claims.

For example, the collar 112 is described above as being in the shape of a ring. However, it should be appreciated that although this configuration is beneficial for the purposes of handling the collar, it is not essential that the collar forms a continuous ring. For example, the manufacturing efficiencies of the invention may still be realised if the collar is in the form of a partial- or split-ring, for example C-shaped.

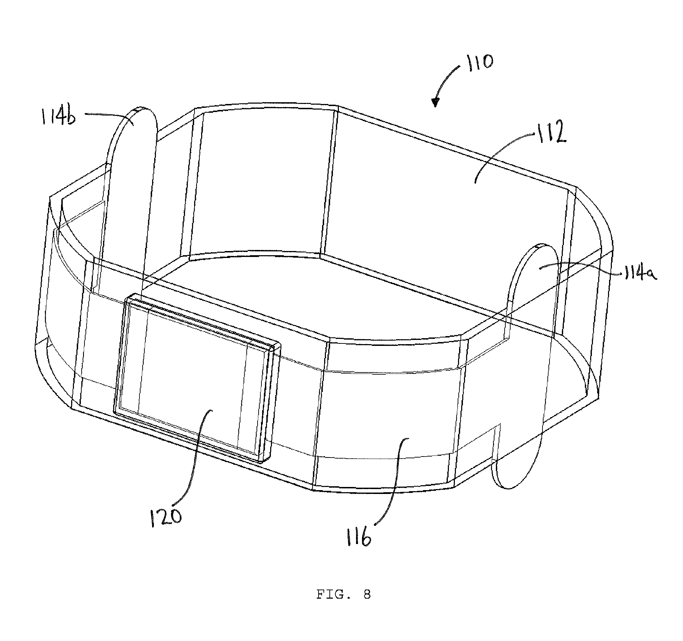

Furthermore, although the connecting collar 112 is described above as including a resistive element in the form of a meandering metallic conductive strip, it will be appreciated that other configurations of resistive element are possible. For example, with reference to Figure 8, in which like parts are denoted by like reference numerals, the resistive link of the collar 112 is embodied by an off-the-shelf chip resistor 120.

Also, although the conductive member 116 has been described herein as in the form of a thin strip of copper, it should be appreciated that other metallic strips would also be within the scope of the invention.

## Claims

1. A piezoelectric actuator (54) for a fuel injector including:
a piezoelectric stack (60);
a connector module (68) associated with the piezoelectric stack (60); and
connecting means (110) for electrically connecting the piezoelectric stack (60) to the connector module (68),
**characterised in that** the connecting means (110) comprises a collar (112) that is received over the piezoelectric stack (60) and is locatable in a position in which the collar (112) contacts a first electrode pair (62a, 62b) provided on the piezoelectric stack (60) and a second electrode pair (102a, 102b) provided on the connector module (68) thereby providing an electrical connection between the connector module (68) and the piezoelectric stack (60).

2. The piezoelectric actuator of claim 1, wherein the collar (112) comprises a ring of insulating material.

3. The piezoelectric actuator of claim 1 or claim 2, wherein the collar (112) includes first and second conductor pads (114a, 114b) housed within the insulating ring that connect the first electrode pair (62a, 62b) provided on the stack (60) to the second electrode pair (102a, 102b) provided on the connector module (68).

4. The piezoelectric actuator of claim 3, wherein the collar (112) further includes a conductive member (116) that connects the first conductor pad (114a) to the second conductor pad (114b) and wherein the conductive member (116) is provided with a resistive element (118) that provides a predetermined resistance between the conductor pads (114a, 114b).

5. The piezoelectric actuator of claim 3 or claim 4, wherein each of the second pair of electrodes (102a, 102b) of the connector module (68) are provided with a recess (115) that is shaped for mutual cooperation with a respective conductor pad (114a, 114b) of the collar (112).

6. The piezoelectric actuator of any one claims 2 to 5, wherein the insulating material is polyimide.

7. The piezoelectric actuator of any one of claims 3 to 6, wherein the conductor pads (114a, 114b) and the conductive member (116) are a copper strip.

8. A connecting element (110) suitable for use with a stack-type piezoelectric actuator (54), the connecting element (110) comprising an non-conductive collar (112) shaped such that a piezoelectric stack (60) is receivable therethrough, in use, wherein the collar (112) includes conductive means (114a, 114b; 116, 118) integrated therein.

9. The connecting element of claim 8, wherein the collar (112) comprises a ring or part-ring of insulating material.

10. The connecting element of claim 9, wherein the collar (112) includes first and second conductive pads (114a, 114b) contained within the ring of insulating material.

11. The connecting element of claim 10, wherein the collar (112) further includes a conductive member (116) that connects the first conductor pad (114a) to the second conductor pad (114b) and wherein the conductive member (116) is provided with a resistive element (118) that provides a predetermined resistance between the conductor pads.

12. The connecting element of any one claims 9 to 11, wherein the insulating material is polyimide.

13. The connecting element of any one of claims 10 to 12, wherein the conductor pads and the conductive member are copper.

14. A method of assembling a piezoelectric actuator (54) including:
providing a piezoelectric stack (60) having distribution electrode means (62a, 62b);
receiving a connecting element (110) according to any one of claims 8 to 13 over the piezoelectric stack (60);
joining a connector module (68) having electrode means (102a, 102b) to the piezoelectric stack (60);
moving the connecting element (110) relative to the stack (60) such that conductive means (114a, 114b; 116, 118) provided in the connecting element (110) engages with the distribution electrode means (62a, 62b) of the piezoelectric stack.

15. The method of claim 14, further including securing the conductive means (114a, 114b; 116, 118) of the connecting element (110) to the distribution electrode means (62a, 62b) of the piezoelectric stack (60) and the electrode means (102a, 102b) of the connector module (68).
